# DEMANDE DE BREVET EUROPEEN

(11) **EP 4 418 828 A1**
(43) Date de publication de la demande: **21.08.2024**
(21) Numéro de dépôt: 24155876.6
(22) Date de dépôt: 05.02.2024
(51) Int. Cl.: H05K 7/14, H05K 9/00

(54) **COMPOSANT ÉLECTRONIQUE DESTINÉ À ÊTRE EMBARQUÉ SUR UN VÉHICULE**

(30) Priorité: 17.02.2023 FR 2301477
(71) Demandeur: Valeo eAutomotive Germany GmbH, 91056 Erlangen (DE)
(72) Inventeur: MORTAIN, Eloi, 95892 Cergy Pontoise (FR); DOUILLARD, Sebastien, 95892 Cergy Pontoise (FR); HARY, Sebastien, 95892 Cergy Pontoise (FR); DUQUENOY, Jeremie, 95892 Cergy Pontoise (FR); RAVIKUMAR, Ajaykumar, 600130 Chennai - Tamil Nadu (IN)
(74) Mandataire: Valeo Powertrain Systems

(57) **Abrégé**

Composant électronique (1) destiné à être embarqué sur un véhicule, le composant comprenant :
une première carte électronique (30) portant au moins un convertisseur de tension (12), ce convertisseur mettant en oeuvre des interrupteurs électroniques commandés par au moins une unité de commande apte à échanger un signal de commande avec une unité de contrôle distante via un connecteur de commande (35), , et
une deuxième carte électronique (33) portant un étage de filtrage (37) appliqué à un signal de puissance, véhiculant notamment un courant alternatif, la deuxième carte électronique (33) étant reliée à la première carte électronique (30),
caractérisé par le fait que la deuxième carte électronique (33) définit un chemin (38) pour le signal de commande entre le connecteur de commande (35) et la première carte électronique (30).

## Description

La présente invention concerne un composant électronique destiné à être embarqué sur un véhicule. Un tel composant est par exemple intégré à un ensemble pour l'alimentation électrique d'une unité de stockage d'énergie électrique de véhicule, encore appelé « chargeur » de cette d'unité de stockage d'énergie électrique. L'unité de stockage d'énergie électrique est par exemple une batterie, pouvant présenter une tension nominale supérieure à 60V, par exemple supérieure ou égale à 300V, à 400V, à 800V, voire à 1000V. Cet ensemble comprend dans un exemple connu :
- un onduleur/redresseur recevant en entrée une tension alternative et fournissant en sortie une tension continue, et
- un convertisseur DC/DC disposé en aval de l'onduleur/redresseur et connecté à l'unité de stockage d'énergie électrique.

L'ensemble comprend une carte électronique portant au moins un convertisseur de tension, ce convertisseur mettant en oeuvre des interrupteurs électroniques commandés par une unité de commande recevant un signal de commande. Il est connu de monter sur la carte électronique un connecteur de commande coopérant avec un connecteur externe pour acheminer un signal de commande jusqu'à l'unité de commande disposée sur cette carte afin de commander les interrupteurs électroniques. Cette configuration rend nécessaire l'implantation du connecteur de commande sur la carte électronique portant les interrupteurs électroniques, et réduit les possibilités d'implantation de cette carte dans un environnement extérieur. Cette configuration peut également réduire les possibilités de routage dans la carte électronique pour le signal de puissance destiné au convertisseur, une zone de cette carte électronique devant être dédiée au connecteur de commande et au routage du signal de commande.

Il existe un besoin pour remédier aux inconvénients précités.

L'invention a pour but de répondre à ce besoin et elle y parvient, selon l'un de ses aspects, à l'aide d'un composant électronique destiné à être embarqué sur un véhicule, le composant comprenant :
- une première carte électronique portant au moins un convertisseur de tension, ce convertisseur mettant en oeuvre des interrupteurs électroniques commandés par au moins une unité de commande apte à échanger un signal de commande avec une unité de contrôle distante via un connecteur de commande, et
- une deuxième carte électronique portant un étage de filtrage appliqué à un signal de puissance, véhiculant notamment un courant alternatif, et le connecteur de commande, la deuxième carte électronique étant reliée à la première carte électronique,
caractérisé par le fait que la deuxième carte électronique définit un chemin pour le signal de commande entre le connecteur de commande et la première carte électronique.

L'invention permet de déporter la connexion pour le signal de commande à l'extérieur de la carte électronique qui porte le convertisseur de tension. Du fait de ce déport, un acheminement du signal de commande jusqu'à la ou les unités de commande des interrupteurs du convertisseur de tension est nécessaire, cet acheminement se faisant via une autre carte portant un étage de filtrage pour un signal de puissance ensuite traité par le convertisseur de tension. L'invention permet ainsi de réduire l'encombrement associé à l'implantation de la première carte électronique, puisqu'il n'est plus nécessaire de prévoir de place pour un connecteur de commande associé à cette carte. On augmente ainsi les possibilités d'implantation de cette première carte électronique. De façon additionnelle, il est possible de libérer sur cette première carte électronique de la place pour d'autres fonctions du fait de l'absence sur cette première carte du connecteur de commande.

L'acheminement du signal de commande entre le connecteur de commande et la première carte électronique peut se faire exclusivement via la deuxième carte électronique. Autrement dit, il n'y a alors pas d'autre route pour ce signal de commande entre le connecteur de commande et la première carte électronique qu'emprunter le chemin de la deuxième carte électronique.

Le connecteur de commande peut être fixé sur un bord de la deuxième carte électronique. Cette fixation est par exemple une soudure, notamment une soudure à la vague. Ce connecteur de commande est connectable à un connecteur externe relié à l'unité de contrôle distincte, cette unité de contrôle distincte étant par exemple une unité de contrôle centralisée du véhicule (ECU en anglais) ou encore une unité de contrôle externe et connectée via la prise du véhicule.

La première carte électronique et la deuxième carte électronique peuvent être disposées de manière immédiatement adjacente l'une par rapport à l'autre. Cette disposition immédiatement adjacente des deux cartes électroniques peut inclure un chevauchement de ces dernières sur quelques millimètres. En variante, aucun chevauchement n'existe, la première carte et la deuxième carte électronique s'étendant dans des plans parallèles d'une carte à l'autre, sans chevauchement selon une direction perpendiculaire à ces plans.

Qu'il y ait ou non chevauchement, la première carte et la deuxième carte électronique peuvent s'étendre dans des plans parallèles, d'une carte électronique à l'autre.

Le bord portant le connecteur de commande est par exemple le bord de la deuxième carte électronique opposé au bord de cette deuxième carte électronique qui est le plus proche de la première carte électronique.

La première carte électronique peut définir un chemin pour le signal de commande jusque l'unité de commande, le chemin pour ce signal de commande dans la deuxième carte électronique et le chemin pour ce signal de commande dans la première carte électronique étant notamment reliés par un interconnecteur. Cet interconnecteur met par exemple en oeuvre un connecteur de type mâle porté par une des cartes enfiché dans un connecteur de type femelle porté par l'autre des cartes.

Le cas échéant, le signal de commande peut comprendre l'une au moins des données suivantes : mesure de température, mesure de courant, consigne de tension, signal de verrouillage, signal CAN ou KLR30 par exemple.

L'unité de commande portée par la première carte électronique peut elle-même échanger des informations avec des modules portés par la première carte électronique, encore appelés « drivers », ces derniers commandant tout ou partie des interrupteurs électroniques. En variante, la commande des interrupteurs électroniques peut se faire directement via l'unité de commande.

Le chemin pour le signal de commande dans la première carte peut être ménagé par des pistes électriques de la première carte, notamment disposées sur une surface d'extrémité de cette première carte, et le chemin pour le signal de commande dans la deuxième carte peut être ménagé par des pistes électriques de la deuxième carte, notamment disposées sur une surface d'extrémité de cette deuxième carte.

Le chemin pour le signal de puissance dans la première carte peut être ménagé par des pistes électriques de la première carte, notamment disposées sur une surface d'extrémité de cette première carte, et le chemin pour le signal de puissance dans la deuxième carte peut être ménagé par des pistes électriques de la deuxième carte, notamment disposées sur une surface d'extrémité de cette deuxième carte. La connexion entre ces deux chemins de puissance peut se faire par un interconnecteur ou par une connexion vissée, par exemple mettant en oeuvre des barres bus.

Dans tout ce qui précède, les interrupteurs électroniques peuvent être des transistors Mosfet ou des IGBT. Ces interrupteurs électroniques sont par exemple appariés en série pour définir des bras de commutation.

Ces interrupteurs électroniques peuvent définir un unique convertisseur de tension, par exemple un onduleur/redresseur ou un convertisseur DC/DC. En variante, la première carte électronique porte :
- un premier jeu d'interrupteurs électroniques définissant un onduleur/redresseur, et
- un deuxième jeu d'interrupteur électroniques définissant un convertisseur DC/DC.

Dans cette variante, le signal de commande peut être associé à un seul des deux convertisseurs, ou aux deux convertisseurs.

Dans tout ce qui précède, le chemin pour le signal de commande dans la deuxième carte électronique peut être ménagé dans une zone de cette deuxième carte électronique située en bordure de cette deuxième carte. Le fait de confiner la zone de la deuxième carte électronique dédiée au chemin pour le signal de commande en bordure de la deuxième carte électronique peut permettre de laisser le plus de place possible au traitement du signal de puissance par la deuxième carte électronique.

Le chemin pour le signal de commande dans la deuxième carte électronique peut être ménagé dans une zone de cette deuxième carte électronique délimitée par un blindage électromagnétique. Ce blindage permet d'éviter que le signal de commande ne soit pollué par le signal de puissance également acheminé via la deuxième carte électronique.

Ce blindage électromagnétique peut être assuré par un muret métallique, notamment en aluminium, coopérant avec la deuxième carte électronique. Ce muret peut être porté par une paroi du boîtier renfermant tout ou partie du composant électronique, ce muret venant en butée contre la deuxième carte électronique après assemblage du composant électronique. Ce muret est par exemple disposé d'un côté de la carte électronique. Ce blindage électromagnétique peut en variante, ou en combinaison, être assuré par des lames précontraintes élastiquement sur la deuxième carte. La précontrainte élastique des languettes est par exemple exercée par un couvercle dudit boîtier. Ces lames peuvent être disposées du côté de la deuxième carte électronique opposé à celui sur lequel est disposé le muret.

La zone de la deuxième carte électronique délimitée par le blindage électromagnétique peut représenter entre 5 et 15% de la surface de la deuxième carte électronique.

Dans tout ce qui précède, le signal de puissance peut véhiculer un courant alternatif, et l'étage de filtrage peut réaliser un filtrage du courant de mode commun et/ou un filtrage du courant différentiel de ce courant alternatif.

En variante, dans tout ce qui précède, le signal de puissance peut véhiculer un courant continu, et l'étage de filtrage peut réaliser un filtrage des bruits dans ce signal.

Le convertisseur de la première carte électronique est par exemple l'un d'un onduleur/redresseur et d'un convertisseur DC/DC.

La deuxième carte électronique peut ne pas porter de convertisseur de tension.

La première carte électronique peut être monobloc, c'est-à-dire qu'elle comprend un unique PCB portant le convertisseur de tension. En variante, la première carte électronique peut être formée par l'assemblage de plusieurs sous-cartes électroniques.

La deuxième carte électronique peut être monobloc ou être formée par l'assemblage de plusieurs sous-cartes électroniques.

L'invention a encore pour objet, selon un autre de ses aspects, un ensemble pour l'alimentation électrique d'une unité de stockage d'énergie électrique de véhicule, comprenant le composant électronique tel que défini ci-dessus.

Cet ensemble peut comprendre, dans un même boîtier ou non, un onduleur/redresseur et un convertisseur DC/DC. Le convertisseur DC/DC présente par exemple une isolation galvanique, notamment via un transformateur tel qu'un transformateur triphasé.

L'unité de stockage d'énergie électrique est par exemple une batterie pouvant présenter l'une des tensions nominales ci-dessus.

L'invention pourra être mieux comprise à la lecture de la description qui va suivre d'exemples non limitatifs de mise en oeuvre de celle-ci :
- [Fig.1] représente de façon schématique une partie du circuit électrique d'un ensemble pour l'alimentation électrique d'une unité de stockage d'énergie électrique de véhicule
- [Fig.2] représente de façon schématique une partie du composant électronique de la figure 1, et
- [Fig.3] représente de façon schématique une variante de ce qui est représenté sur la figure 2.

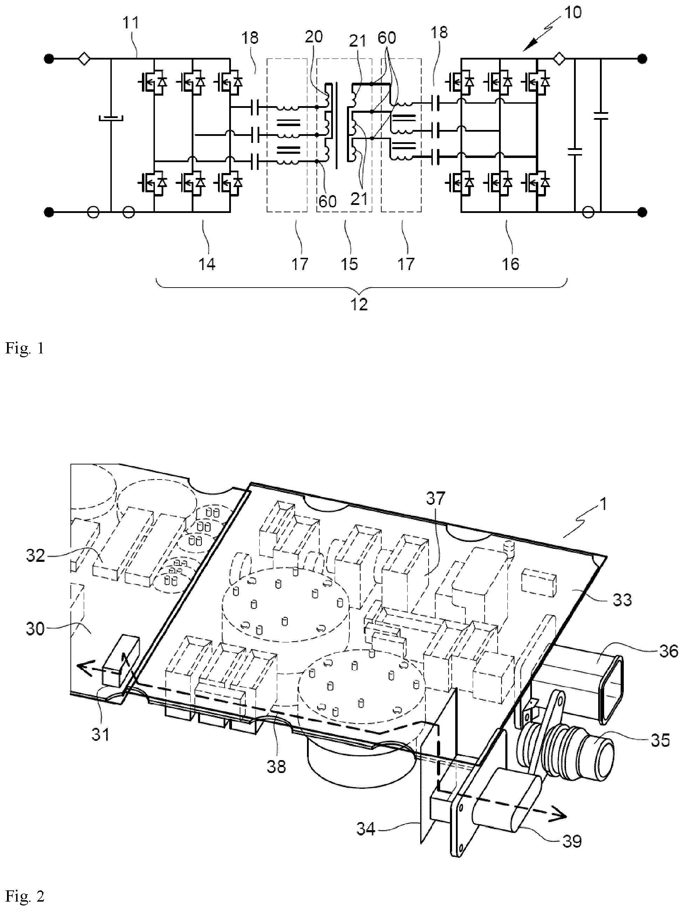

On a représenté sur la figure 1 une partie du circuit électrique 10 d'un ensemble pour l'alimentation électrique d'une unité de stockage d'énergie électrique de véhicule. Cet ensemble est encore appelé « chargeur ». L'unité de stockage d'énergie électrique, non représentée sur cette figure 1, est par exemple une batterie, pouvant présenter une tension nominale supérieure à 60V, par exemple supérieure ou égale à 300V, à 400V, à 800V, voire à 1000V.

Dans l'exemple considéré, le circuit 10 reçoit en entrée une tension alternative d'un réseau non représenté qui est ici triphasé. Un onduleur/redresseur permettant de convertir cette tension alternative en une tension continue, et réalisant également le cas échéant une fonction de correction de facteur de puissance (« Power factor correction » en anglais), est disposé en amont d'un bus continu 11. En aval de ce bus continu, depuis le réseau électrique, est disposé un convertisseur DC/DC isolé 12. Ce convertisseur 12 comprend de façon connue un onduleur 14, un transformateur triphasé 15, et un redresseur 16 fournissant au véhicule une tension continue isolée du réseau électrique. Comme on peut le voir sur la figure 1, le transformateur triphasé 15 est relié à chacun du redresseur 16 et de l'onduleur 14 par un bloc d'inductances 17 et un bloc de condensateurs 18, de manière à définir une structure CLLLC. D'autres structures sont bien entendu possibles, comme une structure LLC, CLLC, LC ou encore CL.

Comme on peut le voir sur la figure 1, chaque phase présente un enroulement primaire 20 et un enroulement secondaire 21 en couplage inductif l'un avec l'autre, et les enroulements primaires 20 sont reliés en étoile et les enroulements secondaires 21 sont également reliés en étoile.

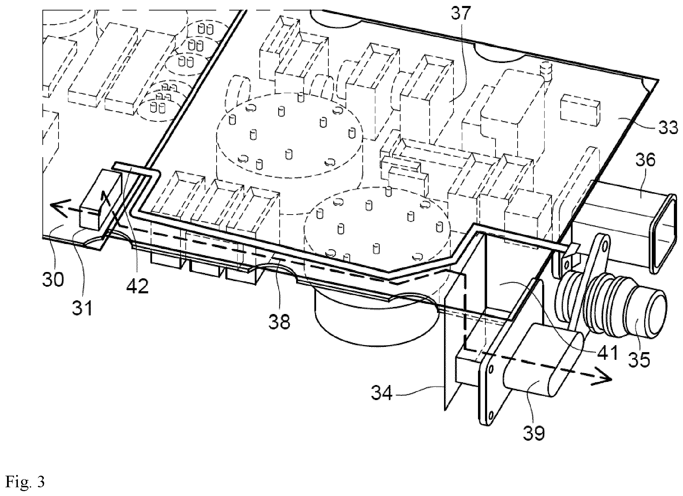

L'un du convertisseur 12 et de l'onduleur/redresseur non représenté sur la figure 1 est ici porté par une première carte électronique 30 d'un composant électronique 1 visible sur les figures 2 et 3. Cette première carte électronique 30 porte par exemple des interrupteurs commandables 32, comme des transistors Mosfet ou des IGBT, ainsi qu'une unité de commande non représentée. L'unité de commande reçoit par exemple d'une unité de contrôle distante, par exemple l'unité de contrôle centralisée du véhicule appelée ECU, des informations de consigne qu'elle traduit en instructions à destination de drivers des interrupteurs. L'unité de commande peut également ou en variante envoyer des informations à l'unité de contrôle distante, par exemple des mesures de température ou de courant ou un signal CAN par exemple.

Le composant électronique 1 comprend, en plus de la première carte électronique 30 une deuxième carte électronique 33 qui est ici disposée de manière immédiatement adjacente par rapport à la première carte électronique 30, comme représenté sur les figures 2 et 3. On constate sur les figures 2 et 3 qu'un léger chevauchement existe entre ces cartes électroniques 30 et 33.

Cette deuxième carte électronique 33 présente, sur un même côté opposé à celui faisant face à la première carte électronique 30, deux connecteurs 34 et 36, et un embout 35 d'un circuit de refroidissement, dans lequel circule par exemple de l'eau. Le connecteur 34 est un connecteur de commande, apte à être connecté à un connecteur de commande externe 39 relié à l'unité de contrôle distante précitée. Le connecteur de puissance 36 est selon l'application un connecteur DC ou un connecteur AC, par exemple monophasé ou triphasé.

Comme on peut le voir, dans l'exemple décrit, la deuxième carte électronique 33 porte un étage de filtrage 37 pour le signal de puissance étant ici une tension alternative triphasée. Cet étage de filtrage 37 est ici constitué de condensateurs et d'inductances pour réaliser un filtrage du courant de mode commun et un filtrage du courant différentiel.

Selon l'invention, le chemin emprunté par le signal de commande entre le connecteur de commande 34 et l'unité de commande est défini non seulement au niveau de la première carte électronique 30, mais également au niveau de la deuxième carte électronique 33.

Dans ce but, une ou plusieurs pistes électriques de la deuxième carte électronique 33 est dédiée au signal de commande définissant ledit chemin 38 dans la deuxième carte électronique 33, et cette piste communique avec les pistes de la première carte électronique 30 reliées à l'unité de commande. Le passage du signal de commande de la première carte électronique 30 à la deuxième carte électronique 33, et réciproquement, se fait dans l'exemple décrit par le biais d'un interconnecteur 31, ce dernier étant par exemple formé par un connecteur de type mâle porté par l'une des cartes 30, 33 et enfiché dans un connecteur de type femelle porté par l'autre des cartes 30, 33.

On constate sur les figures 2 et 3 que le chemin 38 pour le signal de commande dans la deuxième carte électronique 33 est ménagé dans une zone 41 de cette deuxième carte électronique 33 située en bordure de cette deuxième carte 33. Cette zone 41 occupe par exemple une surface comprise entre 5% et 15% de la surface de la deuxième carte électronique 33, par exemple 10% de cette surface.

Comme on peut le voir sur la figure 3, cette zone 41 peut être délimitée par un blindage électromagnétique 42. Ce blindage électromagnétique 42 est par exemple assuré :
- par un muret métallique, notamment en aluminium, coopérant avec la deuxième carte électronique et s'étendant sur un côté de celle-ci depuis une paroi du boîtier renfermant le composant 1, et
- par des lames précontraintes élastiquement sur la deuxième carte par le couvercle du boîtier, ces lames étant disposées sur un côté de cette carte opposé au côté sur lequel est disposé le muret.

L'invention n'est pas limitée à ce qui vient d'être décrit.

Dans une variante, le signal de puissance peut véhiculer un courant continu, et l'étage de filtrage peut réaliser un filtrage des bruits présents dans ce signal continu.

## Revendications

1. Composant électronique (1) destiné à être embarqué sur un véhicule, le composant comprenant :
- une première carte électronique (30) portant au moins un convertisseur de tension (12), ce convertisseur mettant en oeuvre des interrupteurs électroniques (32) commandés par au moins une unité de commande apte à échanger un signal de commande avec une unité de contrôle distante via un connecteur de commande (34), et
- une deuxième carte électronique (33) portant un étage de filtrage (37) appliqué à un signal de puissance, véhiculant notamment un courant alternatif, la deuxième carte électronique (33) étant reliée à la première carte électronique (30),
**caractérisé par le fait que** la deuxième carte électronique (33) définit un chemin (38) pour le signal de commande entre le connecteur de commande (34) et la première carte électronique (30).

2. Composant selon la revendication 1, le connecteur de commande (34) étant fixé sur un bord de la deuxième carte électronique (33).

3. Composant selon la revendication 1 ou 2, la première carte électronique (30) et la deuxième carte électronique (33) étant disposées de manière immédiatement adjacente l'une par rapport à l'autre.

4. Composant selon la revendication 4, la première carte électronique (30) définissant un chemin pour le signal de commande jusque l'unité de commande, le chemin (38) pour ce signal de commande dans la deuxième carte électronique (33) et le chemin pour ce signal de commande dans la première carte électronique (30) étant reliés par un interconnecteur (31).

5. Composant selon la revendication 3 ou 4, la première carte (30) et la deuxième carte électronique (33) s'étendant dans des plans parallèles d'une carte à l'autre, sans chevauchement selon une direction perpendiculaire à ces plans.

6. Composant selon l'une quelconque des revendications précédentes, le chemin (38) pour le signal de commande dans la deuxième carte électronique (33) étant ménagé dans une zone (41) de cette deuxième carte électronique (33) située en bordure de cette deuxième carte (33).

7. Composant selon l'une quelconque des revendications précédentes, le chemin (38) pour le signal de commande dans la deuxième carte électronique (33) étant ménagé dans une zone (41) de cette deuxième carte électronique délimitée par un blindage électromagnétique (42).

8. Composant selon la revendication 5, le blindage électromagnétique (42) étant assuré par un muret métallique, notamment en aluminium, coopérant avec la deuxième carte électronique (33), et/ou le blindage électromagnétique étant assuré par des lames précontraintes élastiquement sur la deuxième carte (33).

9. Composant selon la revendication 7 ou 8, la zone (41) de la deuxième carte électronique (33) délimitée par le blindage électromagnétique (42) représentant entre 5% et 15% de la surface de la deuxième carte électronique (33).

10. Composant selon l'une quelconque des revendications précédentes, l'acheminement du signal de commande entre le connecteur de commande (34) et la première carte électronique (30) se faisant exclusivement via la deuxième carte électronique (33).

11. Composant selon l'une quelconque des revendications précédentes, le signal de puissance véhiculant un courant alternatif et l'étage de filtrage (37) réalisant un filtrage du courant de mode commun et/ou un filtrage du courant différentiel de ce signal de puissance.

12. Composant selon l'une quelconque des revendications précédentes, le convertisseur de la première carte électronique (30) étant l'un d'un onduleur/redresseur et d'un convertisseur DC/DC.

13. Composant selon l'une quelconque des revendications précédentes, la deuxième carte électronique (33) ne portant pas de convertisseur de tension.

14. Composant selon l'une quelconque des revendications précédentes, la première carte électronique (30) étant monobloc et/ou la deuxième carte électronique (33) étant monobloc.

15. Ensemble (1) pour l'alimentation électrique d'une unité de stockage d'énergie électrique de véhicule, comprenant le composant électronique selon l'une quelconque des revendications précédentes.
